# EUROPEAN PATENT APPLICATION

(11) **EP 4 450 677 A1**
(43) Date of publication of application: **23.10.2024**
(21) Application number: 24166864.9
(22) Date of filing: 27.03.2024
(51) Int. Cl.: C23C 18/12, C23C 18/16, C23C 18/18, C23C 18/38, C25D 3/38

(54) **METHOD OF PRODUCING PLATING DEPOSIT**

(30) Priority: 21.04.2023 JP 2023070142
(71) Applicant: C. Uyemura & Co., Ltd., Osaka-shi, Osaka 541-0045 (JP)
(72) Inventor: KOMEDA, Takuya, Hirakata-shi, 573-0065 (JP); YAMAMOTO, Hisamitsu, Hirakata-shi, 573-0065 (JP); ISHIDA, Tetsuji, Hirakata-shi, 573-0065 (JP)
(74) Representative: Manitz Finsterwald Patent- und Rechtsanwaltspartnerschaft mbB

(57) **Abstract**

Provided is a method of producing a plating deposit which enables the production of a plating deposit with good adhesion to a glass substrate. Included is a method of producing a plating deposit, which includes: (1) forming a metal oxide layer on a surface of a glass substrate; (2) performing a first heat treatment after the step (1); (3) forming an electroless copper plating deposit on the metal oxide layer after the step (2); (4) performing a second heat treatment after the step (3); and (5) forming an electrolytic copper plating deposit on the electroless copper plating deposit after the step (4).

## Description

### TECHNICAL FIELD

The present invention relates to a method of producing a plating deposit.

### BACKGROUND ART

The fundamental materials of conventional so-called called printed circuit boards or package substrates mainly include materials in which resin and glass cloth are mixed. When forming a circuit on a conventional material by electrolytic copper plating, an electroless copper plating process has been used to form a base deposit.

### CITATION LIST

### PATENT LITERATURE

Patent Literature 1: JP 2005-256122 A

### SUMMARY OF INVENTION

### TECHNICAL PROBLEM

The increase in the communication speed of electronic devices has led to an increased densification in the fields of printed circuit boards and package substrates. Thus, the level of various specification requirements, such as warpage, coefficient of thermal expansion, smoothness, dielectric constant, and cost, has been increasing. Since high-speed communication uses high frequencies, substrate smoothness is important. Therefore, glass with excellent smoothness has been increasingly used as the fundamental material of substrates instead of conventional mixed resin/glass cloth materials (for example, Patent Literature 1) .

When a glass substrate is subjected to base plating for electrolytic copper plating, it is difficult for the conventional electroless copper plating process to obtain sufficient deposition or adhesion. Thus, it is difficult to obtain a plating deposit with good adhesion by treating a glass substrate with excellent smoothness using the conventional process. Therefore, when forming a circuit on a glass substrate, a copper sputtering process has been used to form a base film instead of the electroless copper plating process. However, the study of the present inventors revealed that the copper sputtering process is poor at coating the inside of through holes in printed circuit boards or package substrates, and therefore a copper plating deposit may not be obtained in the subsequent electrolytic copper plating process, or the copper plating deposit may have insufficient adhesion to the glass substrate. In addition, sputtering devices are expensive and are not suitable for mass production.

As described above, the study of the present inventors revealed that the conventional technique has room for improvement in producing a plating deposit with good adhesion to a glass substrate.

The present invention aims to solve the new problem discovered by the present inventors and provide a method of producing a plating deposit which enables the production of a plating deposit with good adhesion to a glass substrate.

### SOLUTION TO PROBLEM

Embodiment 1 of the present invention relates to a method of producing a plating deposit, including:
(1) forming a metal oxide layer on a surface of a glass substrate;
(2) performing a first heat treatment after the step (1) ;
(3) forming an electroless copper plating deposit on the metal oxide layer after the step (2);
(4) performing a second heat treatment after the step (3); and
(5) forming an electrolytic copper plating deposit on the electroless copper plating deposit after the step (4).

Embodiment 2 of the present invention relates to the method of producing a plating deposit according to Embodiment 1,
wherein the step (1) includes:
   (1-2) applying a catalyst to a surface of a glass substrate; and
   (1-3) forming a metal oxide layer on the surface of the glass substrate, and
the step (1-2) and the step (1-3) are performed in this order.

Embodiment 3 of the present invention relates to the method of producing a plating deposit according to Embodiment 1 or 2,
wherein the metal oxide is a zinc-containing oxide.

Embodiment 4 of the present invention relates to the method of producing a plating deposit according to any one of Embodiments 1 to 3,
wherein the step (1) includes forming the metal oxide layer using an aqueous solution containing zinc ions, nitrate ions, and an amine-borane compound.

Embodiment 5 of the present invention relates to the method of producing a plating deposit according to any one of Embodiments 1 to 4,
wherein the step (3) includes:
   (3-1) applying a catalyst to a surface of the metal oxide layer; and
   (3-2) forming an electroless copper plating deposit on the heat-treated metal oxide layer, and
the step (3-1) and the step (3-2) are performed in this order.

Embodiment 6 of the present invention relates to the method of producing a plating deposit according to any one of Embodiments 1 to 5,
wherein the step (4) is performed in an inert gas atmosphere.

Embodiment 7 of the present invention relates to the method of producing a plating deposit according to any one of Embodiments 1 to 6,
wherein the step (5) includes forming the electrolytic copper plating deposit using an electrolytic copper plating bath with a pH of 2.0 or less.

### ADVANTAGEOUS EFFECTS OF INVENTION

The method of producing a plating deposit according to the present invention includes: (1) forming a metal oxide layer on a surface of a glass substrate; (2) performing a first heat treatment after the step (1); (3) forming an electroless copper plating deposit on the metal oxide layer after the step (2); (4) performing a second heat treatment after the step (3); and (5) forming an electrolytic copper plating deposit on the electroless copper plating deposit after the step (4). This method enables the production of a plating deposit with good adhesion to a glass substrate.

### BRIEF DESCRIPTION OF DRAWINGS

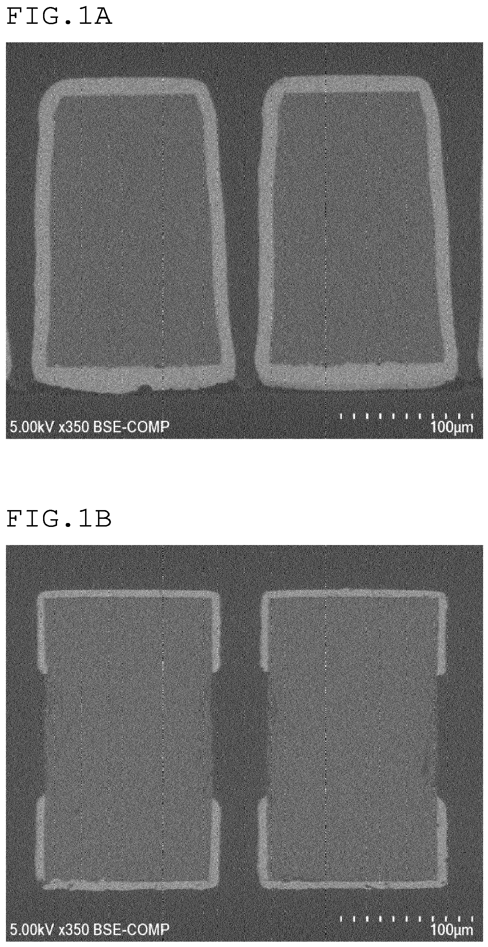

FIGS. 1A and 1B show images of exemplary plating deposits.

### DESCRIPTION OF EMBODIMENTS

The method of producing a plating deposit according to the present invention includes:
(1) forming a metal oxide layer on a surface of a glass substrate;
(2) performing a first heat treatment after the step (1) ;
(3) forming an electroless copper plating deposit on the metal oxide layer after the step (2);
(4) performing a second heat treatment after the step (3); and
(5) forming an electrolytic copper plating deposit on the electroless copper plating deposit after the step (4). Thus, the method enables the production of a plating deposit with good adhesion to a glass substrate.

Although the method of producing a plating deposit according to the present invention is a production method in which the steps (1) to (5) are performed in this order, the method may include additional steps between these steps as long as the steps (1) to (5) are performed in this order (the following order: step (1), step (2), step (3), step (4), and step (5)). Moreover, usual post treatments such as water washing or drying may be performed after each step described below.

The method of producing a plating deposit provides the above-described advantageous effect presumably due to the following reasons.

The adhesion between the glass substrate and the metal oxide can be further increased by the step (1) of forming a metal oxide layer on a surface of a glass substrate and the step (2) of performing a first heat treatment after the step (1). Further, the adhesion between the metal oxide layer and the electroless copper plating deposit can be further increased by the step (3) of forming an electroless copper plating deposit on the metal oxide layer after the step (2) and the step (4) of performing a second heat treatment after the step (3).

The plating deposit formed on the surface of the glass substrate by the steps (1) to (4) has strong adhesion between the glass substrate and the metal oxide and between the metal oxide layer and the electroless copper plating deposit and thus good adhesion to the glass substrate and is therefore very favorable as a base for an electrolytic copper plating deposit. Thus, a plating deposit with good adhesion to a glass substrate can be produced by forming an electrolytic copper plating deposit on the plating deposit formed on the surface of the glass substrate by the steps (1) to (4).

Moreover, in the method of producing a plating deposit in which the steps (1) to (5) are performed in this order, a metal oxide layer and an electroless copper plating deposit can be uniformly formed regardless of the shape of the object to be treated. For this reason, the method is excellent in the deposition and adhesion to the glass substrate surface or the inside of through holes in the substrate.

Herein, "a surface of a glass substrate" refers to an area on the glass substrate. This applies to other similar phrases, such as "a surface of a metal oxide layer" which means an area on the metal oxide layer.

### <Glass substrate>

Non-limiting examples of usable glass substrates include known glass substrates used as circuit substrates in various electronic devices. The glass substrate used is preferably, for example, a glass substrate that can be used to form traces and to produce electronic devices with increasingly higher communication speeds.

The glass substrate may be an amorphous substrate including a silica network and may contain a network former (network-forming oxide) of aluminum, boron, phosphorus, etc. or a network modifier (network-modifying oxide) of an alkali metal, an alkaline-earth metal, magnesium, etc.

Specific examples of the glass constituting the glass substrate include soda glass, soda-lime glass, alkali-free glass, and silica glass. Other preferred examples of the glass constituting the glass substrate include aluminosilicate glass used as a tempered glass.

The amount of glass based on 100% by mass of the glass substrate is preferably 90% by mass or more, more preferably 95% by mass or more, still more preferably 980 by mass or more, and may be 100% by mass. With the above amount, the advantageous effect tends to be achieved more suitably.

Herein, the amount of glass in the glass substrate is measured using an inductively coupled plasma (ICP) emission spectrometer and calculated as the corresponding oxide.

The thickness of the glass substrate is not limited and may be selected appropriately depending on the purpose. Usually, the thickness is about 200 to 1000 um.

### <Step (1)>

The step (1) includes forming a metal oxide layer on a surface of a glass substrate. The step (1) is not limited as long as it includes forming a metal oxide layer on a surface of a glass substrate. For example, the step (1) may include the steps (1-1) to (1-3) described below, or may include the steps (1-1) to (1-3) performed in the following order: the step (1-1), the step (1-2), and the step (1-3). In particular, the step (1) preferably includes the steps (1-2) and (1-3), more preferably the steps (1-2) and (1-3) performed in the following order: the step (1-2) and the step (1-3).

### <<Step (1-1)>>

The step (1-1) includes removing contaminants (foreign substances) from the surface of the glass substrate. Thus, organic residues adsorbed to the surface of the glass substrate can be removed, and the OH groups on the surface of the glass substrate can be increased to improve the hydrophilicity.

In the step (1-1), for example, the surface of the glass substrate may be washed with at least one selected from the group consisting of organic solvents, alkaline solutions, and acidic solutions. These may be used alone or in combinations of two or more. When the surface of the glass substrate is washed with an organic solvent, organic residues adsorbed to the surface of the glass substrate can be removed. When the surface of the glass substrate is washed with an alkaline solution or an acidic solution, organic residues adsorbed to the surface of the glass substrate can be removed, and at the same time the OH groups on the surface of the glass substrate can be increased to improve the hydrophilicity.

Examples of usable organic solvents include methanol, ethanol, acetone, ethyl acetate, and hexane. These may be used alone or in combinations of two or more.

The conditions for washing the glass with an organic solvent are not limited.

Examples of usable alkaline solutions include NaOH solutions and KOH solutions. These may be used alone or in combinations of two or more.

The conditions for washing the glass with an alkaline solution are not limited.

Examples of usable acidic solutions include sulfuric acid, hydrochloric acid, nitric acid, hydrogen peroxide/sulfuric acid, and hydrogen peroxide/nitric acid. These may be used alone or in combinations of two or more.

The conditions for washing the glass with an acidic solution are not limited.

### <<Step (1-2)>>

The step (1-2) includes applying a catalyst (catalytic metal) to the surface of the glass substrate. Thus, the surface of the glass substrate can be activated, and a metal oxide layer can be formed on the surface of the glass substrate more suitably. With the step (1-2), it is also possible to form a metal oxide layer without roughening the surface of the glass substrate. Thus, fine pitch trace patterns can be formed in circuit formation, and the influence on the transmission loss in a high frequency band can also be reduced. Moreover, although a fluoride is usually used to roughen the surface of a glass substrate, the use of a fluoride is inappropriate in view of the safety of the human body and environmental protection. With the step (1-2), it is possible to form a metal oxide layer on the surface of the glass substrate without using a fluoride.

The catalytic metal used may be any metal that has catalytic activity for forming a metal oxide layer in the subsequent step. Examples include Ag, Pd, Pt, and Au. These may be used alone or in combinations of two or more. In particular, Pd and Ag are preferred, with Pd being more preferred.

The method for applying a catalyst to the surface of the glass substrate is also not limited because what is important is to apply a catalyst (catalytic metal) to the surface of the glass substrate. Examples include a method in which metal ions are adsorbed onto the glass substrate to reduce them into the metal, and a method in which a metal colloids are adsorbed onto the glass substrate. These may be used alone or in combinations of two or more. The conditions for applying a catalyst are also not limited for the same reason.

An exemplary specific method of the step (1-2) may include cleaner conditioning (promoted catalyst adsorption, uniform catalyst adsorption), predipping, catalyst application (activator), and activation treatment (accelerator) in this order.

### <<Step (1-3)>>

The step (1-3) includes forming a metal oxide layer on the surface of the glass substrate. Thus, a metal oxide layer can serve as an intermediate layer between the glass and an electroless copper plating, so that the adhesion between the glass and the electroless copper plating can be easily improved.

In the step (1-3), a metal oxide layer is preferably formed on the surface of the glass substrate to which a catalyst (catalytic metal) has been applied. Thus, the advantageous effect tends to be achieved more suitably.

The metal oxide is preferably a zinc-containing oxide, examples of which include zinc oxide and oxides of alloys containing zinc and at least one metal selected from the group consisting of titanium, aluminum, silicon, tin, zirconium, nickel, indium, vanadium, chromium, iron, manganese, cobalt, and copper. These may be used alone or in combinations of two or more. Preferred among these are zinc oxide and oxides of alloys containing zinc and at least one metal selected from the group consisting of indium, titanium, silicon, tin, manganese, and cobalt, with zinc oxide being more preferred.

The thickness of the metal oxide layer is preferably 0.05 to 0.5 um, more preferably 0.1 to 0.3 um. With the above thickness, good adhesion tends to be obtained with high productivity.

For example, the metal oxide layer may be formed by immersing the catalyst-applied glass substrate in a treatment liquid for metal oxide layer formation. The treatment liquid for metal oxide layer formation is preferably an aqueous solution containing zinc ions, nitrate ions, and an amine-borane compound.

The zinc ion source used may be a water-soluble zinc salt, examples of which include zinc nitrate, zinc sulfate, zinc chloride, zinc acetate, zinc phosphate, zinc pyrophosphate, and zinc carbonate. Zinc nitrate is preferred among these. These may be used alone or in combinations of two or more.

The nitrate ion source used may be nitric acid, a water-soluble nitrate, etc. Examples include nitric acid, zinc nitrate, ammonium nitrate, sodium nitrate, potassium nitrate, lithium nitrate, and urea nitrate. Zinc nitrate is preferred among these. These may be used alone or in combinations of two or more.

Preferably, zinc nitrate alone is used as an ion source of both the zinc ions and the nitrate ions.

The zinc ion concentration and nitrate ion concentration in the treatment liquid for metal oxide layer formation may be adjusted in a wide range. However, if even one of these ion concentrations is too low, a metal oxide film cannot be formed, while if even one of these ion concentrations is too high, a metal hydroxide film is likely to be formed, so that the purity of the metal oxide film is likely to decrease. Therefore, the zinc ion concentration and nitrate ion concentration are each preferably within a range of about 0.001 mol/l to about 0.5 mol/l (0.065 to 32.7 g/l in terms of zinc content), more preferably within a range of about 0.01 mol/l to about 0.2 mol/l (0.65 to 13 g/l in terms of zinc content).

The amine-borane compound may be any water-soluble amine-borane compound, examples of which include dimethylamine-borane and trimethylamine-borane. These may be used alone or in combinations of two or more. Dimethylamine-borane is preferred among these.

The amine-borane compound concentration in the treatment liquid for metal oxide layer formation is preferably 0.3 to 20 g/L, more preferably 0.5 to 5 g/L. With the above concentration, good metal oxide deposition tends to be obtained with high productivity.

The pH of the treatment liquid for metal oxide layer formation is preferably 3.0 to 7.0, more preferably 4.0 to 7.0. With the above pH, good metal oxide deposition tends to be obtained with high productivity.

The temperature in the metal oxide formation treatment is preferably 50°C to 90°C, more preferably 60°C to 85°C. With the above temperature, the decomposition reaction rate of the amine-borane compound can be adjusted within an appropriate range, and good metal oxide deposition tends to be obtained.

The duration of the metal oxide formation treatment is preferably 2 to 180 minutes, more preferably 5 to 60 minutes, still more preferably 10 to 30 minutes. When the duration is 2 minutes or more, a metal oxide layer having a sufficient thickness can be formed, and sufficient adhesion between the glass substrate and the metal oxide tends to be obtained. Moreover, although a duration of more than 180 minutes is usually required to form a metal oxide layer, the present invention can reduce the treatment duration by using an aqueous solution containing zinc ions, nitrate ions, and an amine-borane compound as a treatment liquid for metal oxide layer formation, and thus can form a metal oxide layer with high productivity and cost advantages.

The steps (1-2) and (1-3) enable the formation of a metal oxide layer on the surface of the glass substrate without using a fluoride. The fluorine content of the metal oxide layer is preferably 0.1% by mass or lower, more preferably 0.01% by mass or lower, still more preferably zero (0% by mass) based on 100% by mass of the metal oxide layer. With the above content, the advantageous effect tends to be achieved more suitably.

Herein, the fluorine content is measured using a fluoride ion electrode.

The method of producing a plating deposit according to the present invention does not need to use a fluoride and therefore does not require a step of removing fluorine from the metal oxide layer. In other words, the method of producing a plating deposit according to the present invention, which does not include a step of removing fluorine from the metal oxide layer, can produce a plating deposit with good adhesion to a glass substrate with high productivity.

### <Step (2)>

The step (2) includes performing a first heat treatment after the step (1). Specifically, in the step (2), the glass substrate in which a metal oxide layer has been formed on the surface in the step (1) is subjected to a first heat treatment. Thus, some metal hydroxide remaining in the metal oxide layer formation in the step (1) can be converted to a metal oxide by a dehydration reaction, and chemical bonds can be formed between the glass substrate and the metal oxide by condensation of OH groups, so that the adhesion between the glass substrate and the metal oxide can be further increased.

Although the step (2) may be performed in any atmosphere, the atmosphere preferably contains oxygen to promote the dehydration reaction. Thus, for example, the step (2) may be performed in the air atmosphere.

The temperature in the heat treatment is preferably 100°C to 800°C, more preferably 200°C to 600°C, still more preferably 250°C to 500°C, particularly preferably 300°C to 450°C, most preferably 300°C to 350°C. When the temperature is 100°C or higher, the dehydration reaction tends to proceed sufficiently, resulting in better adhesion between the glass substrate and the metal oxide. When the temperature is 800°C or lower, it tends to be possible to further reduce the dimensional changes, such as warpage or distortion, of the glass substrate.

The duration of the heat treatment is preferably 5 to 180 minutes, more preferably 15 to 90 minutes, still more preferably 25 to 90 minutes. With the above duration, the dehydration reaction tends to proceed sufficiently without reducing the productivity, resulting in better adhesion between the glass substrate and the metal oxide.

### <Step (3)>

The step (3) includes forming an electroless copper plating deposit on the metal oxide layer after the step (2). Specifically, in the step (3), an electroless copper plating deposit is formed on the heat-treated metal oxide layer after the step (2).

The step (3) is not limited as long as it includes forming an electroless copper plating deposit on the metal oxide layer. For example, the step (3) may include the steps (3-1) and (3-2) described below, or may include the steps (3-1) and (3-2) performed in the following order: the step (3-1) and the step (3-2).

### <<Step (3-1)>>

The step (3-1) includes applying a catalyst (catalytic metal) to a surface of the metal oxide layer. Thus, the surface of the metal oxide layer can be activated, and an electroless copper plating deposit can be formed on the surface of the metal oxide layer more suitably. Moreover, with the step (3-1), it is possible to form an electroless copper plating deposit without roughening the surface of the metal oxide layer. Thus, the influence on the transmission loss in a high frequency band can also be reduced.

The catalytic metal may be any metal that has catalytic activity for forming an electroless copper plating deposit in the subsequent step. Examples include Cu, Ni, Ag, Pd, Pt, and Au. These may be used alone or in combinations of two or more. Pd, Ag, Pd, and Pt are preferred among these, with Pd being more preferred.

The method for applying a catalyst is not limited because what is important is to apply a catalyst (catalytic metal) to the surface of the metal oxide layer. Examples include a method in which metal ions are substituted on the metal oxide, and (1) metal ion substitution may be followed by (2) immersion in a reducing agent solution to activate the catalytic metal. The composition of the catalyst application bath is also not limited.

The pH of the catalyst application bath is preferably 3.0 to 13, more preferably 4.0 to 7.0. With the above pH, the dissolution of the metal oxide layer can be further reduced, and a decrease in adhesion can be further reduced.

Herein, the pH is measured at 25°C.

Herein, the metal concentrations or metal contents are measured with an inductively coupled plasma (ICP) emission spectrometer.

Also, herein, the concentration of each compound in the liquid is measured by liquid chromatography (Shimadzu Corporation).

The catalyst (catalytic metal) can be applied to the surface of the metal oxide layer by bringing the surface of the metal oxide layer into contact with the catalyst application bath. Specific methods are not limited. Usually, the object to be treated may be immersed in the catalyst application bath. Alternatively, the catalyst application treatment can also be performed by spraying or applying the catalyst application bath to the surface of the material to be electroless plated.

The temperature in the catalyst application treatment is preferably 10°C to 60°C, more preferably 20°C to 40°C. When the temperature is 10°C or higher, the amount of catalyst application tends to be sufficient, resulting in good electroless copper plating deposition. When the temperature is 60°C or lower, the dissolution of the metal oxide layer can be further reduced, and a decrease in adhesion can be further reduced.

The duration of the catalyst application treatment is preferably 10 seconds to 10 minutes, more preferably 30 seconds to 5 minutes. When the duration is 10 seconds or more, the amount of catalyst application tends to be sufficient, resulting in good electroless copper plating deposition. When the duration is 10 minutes or less, the dissolution of the metal oxide layer can be further reduced, and a decrease in adhesion can be further reduced.

When (1) metal ion substitution is followed by activating the catalytic metal, examples of the reducing agent used in (2) include dimethylamine-borane, trimethylamine-borane, sodium hypophosphite, sodium phosphite, formaldehyde, glyoxylic acid, hydrazine, and sodium formate. These may be used alone or in combinations of two or more.

The treatment conditions (temperature, etc.) for activating the catalytic metal are not limited as long as the bath used is of a type having a pH of 3.0 or more. When the pH is 3.0 or more, the dissolution of the metal oxide layer can be further reduced, and a decrease in adhesion can be further reduced.

Another feature of the present invention is to perform a step (3-1) of applying a catalyst (catalytic metal) to the surface of the metal oxide layer after the first heat treatment. Thus, a plating deposit with good adhesion to a glass substrate can be produced with high productivity.

In contrast, if the first heat treatment is performed after applying a catalyst (catalytic metal) to the surface of the metal oxide layer, the catalyst can be oxidized so that an electroless copper plating deposit cannot be formed sufficiently. Thus, a reduction treatment needs to be performed after the heat treatment, resulting in a decrease in productivity.

### <<Step (3-2) >>

The step (3-2) includes forming an electroless copper plating deposit on the heat-treated metal oxide layer. Thus, conduction on the metal oxide layer can be provided, which enables electrolytic copper plating.

In the step (3-2), an electroless copper plating deposit is preferably formed on the surface of the metal oxide layer to which a catalyst (catalytic metal) has been applied. Thus, the advantageous effect tends to be achieved more suitably.

The thickness of the electroless copper plating deposit is preferably 0.1 to 2 um, more preferably 0.5 to 1 um. When the thickness is 0.1 µm or more, the dissolution of the metal oxide layer can be further reduced even when using a strong acid electrolytic copper plating bath, and it tends to be possible to reduce a decrease in adhesion. When the thickness is 2 µm or less, insufficient adhesion between the glass substrate and the metal oxide due to the stress of the electroless copper plating deposit can be further inhibited.

For example, the electroless copper plating deposit may be formed by bringing an electroless copper plating bath into contact with the surface of the metal oxide layer to which a catalyst (catalytic metal) has been applied.

The electroless copper plating bath is not limited. The treatment conditions (temperature, pH, etc.) for electroless copper plating are not limited either.

### <Step (4)>

The step (4) includes performing a second heat treatment after the step (3). Specifically, in the step (4), the glass substrate in which an electroless copper plating deposit has been formed on the surface in the step (3) is subjected to a second heat treatment. Thus, a diffusion layer can be formed between the metal oxide layer and the electroless copper plating deposit, and the adhesion between the metal oxide and the electroless copper plating can be further increased.

The atmosphere in the step (4) is preferably an inert gas atmosphere such as nitrogen, argon, or helium gas atmosphere. When the step (4) is performed in an inert gas atmosphere, it tends to be possible to inhibit excessive oxidation of the electroless copper plating deposit and to produce a plating deposit with better adhesion to the glass substrate.

The temperature in the heat treatment is preferably 100°C to 600°C, more preferably 200°C to 500°C, still more preferably 300°C to 450°C. When the temperature is 100°C or higher, a diffusion layer tends to be formed sufficiently, resulting in better adhesion between the metal oxide and the electroless copper plating. When the temperature is 600°C or lower, it tends to be possible to further reduce the dimensional changes, such as warpage or distortion, of the glass substrate.

The duration of the heat treatment is preferably 5 to 180 minutes, more preferably 15 to 90 minutes, still more preferably 25 to 90 minutes. With the above duration, a diffusion layer tends to be formed sufficiently without reducing the productivity, resulting in better adhesion between the metal oxide and the electroless copper plating.

### <Step (5)>

The step (5) includes forming an electrolytic copper plating deposit on the electroless copper plating deposit after the step (4). Specifically, in the step (5), an electrolytic copper plating deposit is formed on the heat-treated electroless copper plating deposit after the step (4) .

Although the thickness of the electrolytic copper plating deposit is not limited, it is, for example, 10 to 20 µm.

For example, the electrolytic copper plating deposit may be formed by bringing an electrolytic copper plating bath into contact with the electroless copper plating deposit.

Although the electrolytic copper plating bath is not limited, it preferably contains a water-soluble copper salt, sulfuric acid, and chloride ions.

The water-soluble copper salt is contained as a copper ion source, and examples include copper compound salts such as copper sulfate, copper chloride, copper oxide, copper carbonate, copper pyrophosphate, copper fluoroborate, copper methanesulfonate, copper propanesulfonate, copper isethionate, and copper propanol sulfonate. Each of these copper compounds may be used alone, or two or more of these may be used in combination. In the case of copper sulfate, for example, the water-soluble copper salt concentration in the copper plating bath is preferably 30 to 300 g/L, more preferably 70 to 90 g/L, calculated as copper sulfate pentahydrate.

The sulfuric acid concentration in the electrolytic copper plating bath is preferably 30 to 300 g/L, more preferably 180 to 220 g/L. When the sulfuric acid concentration is 30 g/L or more, the thickness of the copper film within the plated surface tends to be uniform. When the sulfuric acid concentration is 300 g/L or less, it tends to be possible to dissolve the water-soluble copper salt sufficiently.

The chloride ion concentration in the electrolytic copper plating bath is preferably 5 to 150 mg/L, more preferably 20 to 100 mg/L, still more preferably 30 to 60 mg/L. When the chlorine ion concentration is 150 mg/L or less, it tends to be possible to further inhibit passivation of the anode caused by formation of copper chloride on the anode surface. When the chlorine ion concentration is 5 mg/L or more, it tends to be possible to inhibit the suppressing action from partially taking place and to further reduce the risk of step plating.

The electrolytic copper plating bath preferably contains a leveler (leveling agent) in addition to the above-described components. Here, the term "leveler" refers to an additive including a nitrogen-containing compound, which can act as a cation in an acidic plating bath and electrically concentrate on a high current density portion, for example, on the outer surface side of via holes or through holes in the object to be plated, thereby increasing the activation overvoltage and inhibiting copper deposition. On the other hand, the leveler will be less adsorbed to the bottom of fine grooves or holes, or other similar locations to allow copper to preferentially deposit there for bottom-up deposition, thereby exhibiting leveling properties.

The leveler may be any nitrogen-containing organic compound. Examples include polyethylene imine and derivatives thereof, polyvinyl imidazole and derivatives thereof, polyvinyl alkyl imidazoles and derivatives thereof, copolymers of vinylpyrrolidone and vinyl alkyl imidazoles or derivatives thereof, dyes such as Janus Green B, diallyl dimethyl ammonium chloride polymers, diallyl dimethyl ammonium chloride/sulfur dioxide copolymers, partially 3-chloro-2-hydroxypropylated diallylamine hydrochloride/diallyl dimethyl ammonium chloride copolymers, diallyl dimethyl ammonium chloride/acrylamide copolymers, diallylamine hydrochloride/sulfur dioxide copolymers, allylamine hydrochloride polymers, (free) allylamine polymers, allylamine hydrochloride/diallylamine hydrochloride copolymers, diamine/epoxy polymerization products, morpholine/epichlorohydrin polymerization products, and epichlorohydrin-modified products of polycondensates of diethylenetriamine, adipic acid, and ε-caprolactam.

The leveler concentration in the electrolytic copper plating bath is preferably 0.01 to 3000 mg/L.

The electrolytic copper plating bath preferably contains a brightener in addition to the above-described components. The term "brightener" refers to an additive that can inhibit the growth of crystals and promote the formation of growth nuclei in plating deposition to form a dense microcrystalline plating deposit. It enables the production of a glossy deposit.

The brightener may be any sulfur-containing organic compound, and examples include sulfur-containing compounds represented by the following formulas:

**R1-S-(CH₂)n-(O)ₚ-SO₃M** ··· (1)

**(R2)₂N-CSS-(CH₂)n-(CHOH)ₚ-(CH₂)n-(O)ₚ-SO₃M** ··· **(2)**

**R2-O-OSS-(CH₂)n-(CHOH)p-(CH₂)n-(O)ₚ-SO₃M** ··· (3)

wherein R1 represents a hydrogen atom or a group represented by the formula: -(S)ₘ-(CH₂)ₙ- (O)ₚ-SO₃M; each R2 independently represents a C1-C5 alkyl group; M represents a hydrogen atom or an alkali metal; m is 0 or 1; n is an integer of 1 to 8; and p is 0 or 1.

The brightener concentration in the electrolytic copper plating bath is preferably 0.01 to 1000 mg/L.

The electrolytic copper plating bath preferably contains a carrier in addition to the above-described components. The term "carrier" refers to an additive that can interact with chloride ions and adsorb to the copper surface to form a monomolecular film, thereby uniformly inhibiting the growth of crystals. It improves uniform electrodeposition.

The carrier may be any polyether compound. Examples of the polyether compound include compounds containing polyalkylene glycols with at least four -O- groups. Further, specific examples include polyethylene glycol, polypropylene glycol, and copolymers of these glycols, polyethylene glycol fatty acid esters, and polyethylene glycol alkyl ethers.

The carrier concentration in the electrolytic copper plating bath is preferably 5 to 5000 mg/L.

The treatment conditions for electrolytic copper plating are not limited. However, the pH of the electrolytic copper plating bath is preferably 6.0 or less, more preferably 4.0 or less, still more preferably 2.0 or less, particularly preferably 1.5 or less, while the lower limit is not limited. With the above pH, the advantageous effect tends to be achieved more suitably. Moreover, the temperature in the electrolytic copper plating is preferably 37°C to 43°C, and the current density is preferably 3 to 5 A/dm².

### <<Other steps>>

The method of producing a plating deposit according to the present invention includes the steps (1) to (5) in this order. The method may include other steps as long as the steps (1) to (5) are performed in this order.

Examples of other steps include steps of performing electroless nickel plating, electroless silver plating, electroless cobalt plating, or electroless palladium plating between the steps (2) and (3). The chemical liquid used in each step may be appropriately selected from known ones.

Although the total thickness of the plating deposit (plating deposit laminate) produced by the method of producing a plating deposit according to the present invention is not limited, it is, for example, 10 to 20 um.

Herein, the thickness and total thickness of the plating deposits, etc. are each the average of those measured at five locations using an X-ray fluorescence spectrometer.

The treatment conditions and concentration settings in the treatments described above are not limited to the conditions described above and may obviously be changed appropriately depending on the thickness of the deposit to be formed and other factors.

The plating deposit produced by the method of producing a plating deposit according to the present invention has good adhesion to a glass substrate. Therefore, the plating deposit according to the present invention is preferably used in a printed circuit board or package substrate, more preferably a high-density printed circuit board, for an electronic device. Since the present invention enables the formation of a plating deposit (traces) with good adhesion to a glass substrate, the plating deposit is most suitable for production of electronic devices with increasingly higher communication speeds.

Examples of the electronic devices include home appliances, in-vehicle equipment, power transmission systems, transportation equipment, and communication equipment. Specific examples include power modules, power control units, etc. for air conditioners, elevators, electric vehicles, hybrid vehicles, trains, and power generation equipment, general home appliances, and personal computers.

### EXAMPLES

The present invention will be specifically described with reference to examples, but the invention is not limited to these examples.

An alkali-free glass (ABC-1, available from Nippon Electric Glass Co., Ltd.) cut into a 50 mm × 50 mm size was used as a glass substrate. A plating deposit was formed on the glass substrate according to the conditions shown in Tables 1 and 2. Here, the steps in Table 1 are performed in the order from top to bottom. It should be noted that if there is a discrepancy between the conditions in the tables and those described hereinabove, the conditions in the tables shall take precedence.

### (Examples)

### (Step (1-1))

The surface of the glass substrate was subjected to alcohol washing using ethanol at 25°C for five minutes and then washed with water at a temperature of 25°C for one minute. Next, the surface of the glass substrate was subjected to alkali washing using a sodium hydroxide aqueous solution at 50°C for five minutes and then washed with water at a temperature of 25°C for one minute.

### (Step (1-2))

The surface of the glass substrate was subjected to cleaner conditioning using THRU-CUP MTE-1A available from C.Uyemura & Co., Ltd. at 50°C for five minutes, then washed with water at a temperature of 40°C for one minute, and further washed with water at a temperature of 25°C for one minute. Next, the surface of the glass substrate was subjected to predipping using THRU-CUP PED-104 available from C.Uyemura & Co., Ltd. at 25°C for two minutes. Subsequently, activator treatment was performed using THRU-CUP AT-105 available from C.Uyemura & Co., Ltd. at 30°C for eight minutes, followed by water washing at a temperature of 25°C for one minute. Subsequently, the surface of the glass substrate was subjected to accelerator treatment using THRU-CUP ALF-406-A ACCELERATOR available from C.Uyemura & Co., Ltd. at 25°C for three minutes and then washed with water at a temperature of 25°C for one minute. Palladium (Pd) was applied to the surface of the glass substrate by the step (1-2).

### (Step (1-3))

The catalyst-applied glass substrate was immersed in the treatment liquid for metal oxide layer formation (containing zinc nitrate hexahydrate and dimethylamine-borane, pH 6.0) shown in Table 1 at 80°C for 20 minutes. Subsequently, the glass substrate was washed with water at a temperature of 25°C for one minute and then dried with a dryer at a temperature of 60°C for 10 minutes. Thus, a metal oxide layer (zinc oxide layer, thickness 0.3 um) was formed on the surface of the glass substrate.

### (Step (2))

The glass substrate with the metal oxide layer formed thereon was subjected to a first heat treatment under the conditions shown in Table 2.

### (Step (3-1))

The glass substrate heat-treated in the step (2) was immersed in a catalyst application bath (ALCUP MAT-2-A ACTIVATOR available from C.Uyemura & Co., Ltd., pH 5.0) at 25°C for one minute. Subsequently, the glass substrate was washed with water at a temperature of 25°C for one minute. Thus, palladium (Pd) was applied to the surface of the metal oxide layer.

### (Step (3-2))

The glass substrate obtained in the step (3-1) was immersed in THRU-CUP PEA ver.2 available from C.Uyemura & Co., Ltd. at 36°C for 20 minutes. Subsequently, the glass substrate was washed with water at a temperature of 25°C for one minute and then dried with a dryer at a temperature of 60°C for 10 minutes. Thus, an electroless copper plating deposit (thickness 0.7 um) was formed on the surface of the metal oxide layer.

### (Step (4))

The glass substrate with the electroless copper plating deposit formed thereon was subjected to a second heat treatment under the conditions shown in Table 2.

### (Step (5))

The glass substrate obtained in the step (4) was washed with sulfuric acid at 25°C for 10 seconds and then immersed in THRU-CUP ECD-H (pH 1.0 or less) available from C.Uyemura & Co., Ltd. at a temperature of 40°C and a current density of 3 A/dm² for 23 minutes. Subsequently, the glass substrate was washed with water at a temperature of 25°C for one minute, and then dried with a dryer at a temperature of 60°C for 10 minutes and heat-treated in the air at 200°C for 60 minutes. Thus, an electrolytic copper plating deposit (thickness 15 um) was formed on the surface of the electroless copper plating deposit. Here, the THRU-CUP ECD-1A, THRU-CUP ECD-4B, and THRU-CUP ECD-H available from C.Uyemura & Co., Ltd. shown in Table 1 correspond to a leveler, brightener, and carrier, respectively, as described above.

### (Comparative Examples 1 and 2)

A plating deposit was formed as in the examples according to the conditions shown in Table 2.

### (Comparative Example 3)

An alkali-free glass (ABC-1, available from Nippon Electric Glass Co., Ltd.) cut into a 50 mm × 50 mm size was used as a glass substrate. At GEOMATEC Co., Ltd., a 100 nm Ti layer was sputtered on the glass substrate, and then a 200 nm Cu layer was sputtered thereon. The glass substrate with the sputtered Ti and Cu layers was washed with sulfuric acid at 25°C for 10 seconds and then immersed in THRU-CUP ECD-H (pH 1 or less) available from C.Uyemura & Co., Ltd. at a temperature of 40°C and a current density of 3 A/dm² for 23 minutes. Subsequently, the glass substrate was washed with water at a temperature of 25°C for one minute, and then dried with a dryer at a temperature of 60°C for 10 minutes and heat-treated in the air at 200°C for 60 minutes. Thus, an electrolytic copper plating deposit (thickness 15 um) was formed on the sputtered Cu surface.

### <Measurement of thickness of deposit>

The thickness of each deposit was calculated as the average of those measured at five locations using an X-ray fluorescence spectrometer (available from Hitachi High-Tech Science Corporation, trade name: SFT-9550) was determined as the thickness of the deposit.

### <Adhesion evaluation>

The adhesion of each plating deposit was evaluated by making a 10 mm wide cut in the glass substrate with the plating deposit using a box cutter, peeling the electrolytic copper plating deposit using a tensile testing machine (AGS-X available from Shimadzu Corporation), and measuring the peel strength. The following evaluation criteria were used in the adhesion evaluation. A higher peel strength value is considered better adhesion. Table 2 shows the results.
S (Excellent): The peel strength is at least 300 gf/cm.
A (Good): The peel strength is at least 200 gf/cm but less than 300 gf/cm.
B (Fair): The peel strength is at least 100 gf/cm but less than 200 gf/cm.
C (Bad): The peel strength is less than 100 gf/cm.

**[Table 1]**

| Step | Chemical liquid | Concentration | Tem perature (°C) | Duration (min) |
|---|---|---|---|---|
| Alcohol washing | Ethanol | 1000 mL/L | 25 | 5 |
| Water washing | | | R.T. | 1 |
| Alkali washing | Sodium hydroxide | 200 g/L | 50 | 5 |
| Water washing | | | R.T. | 1 |
| Cleaner | THRU-CUP MTE-1-A | 50 mL/L | 50 | 5 |
| Hot water washing | | | 40 | 1 |
| Water washing | | | R.T. | 1 |
| Predipping | THRU-CUP PED-104 | 270 g/L | 25 | 2 |
| Pd catalyst application | THRU-CUP PED-104 | 270 g/L | 30 | 8 |
| | THRU-CUP AT-105 | 30 mL/L | | |
| Water washing | | | R.T. | 1 |
| Pd catalyst activation | THRU-CUP ALF-406-A ACCELERATOR | 150 mL/L | 25 | 3 |
| Water washing | - | | R.T. | 1 |
| Metal oxide layer formation | Zinc nitrate hexahydrate | 15 g/L | 80 | 20 |
| | Dimethylamine-borane | 1 g/L | | |
| Water washing | - | | R.T. | 1 |
| Drying | - | | 60 | 10 |
| Heat treatment | - | Conditions shown in Table 2 | | |
| Pd catalyst application | ALCUP MAT-2-AACTIVATOR | 10 mL/L | 25 | 1 |
| Water washing | | | R.T. | 1 |
| Electroless copper plating | THRU-CUP PEA ver.2 (with the following ingredients) | Standard bath concentration | 36 | 20 |
| | THRU-CUP PEA-6-A | 100 mUL | | |
| | THRU-CUP PEA-6-B-2X | 50 mL/L | | |
| | THRU-CUP PEA-6-C | 14 mL/L | | |
| | THRU-CUP PEA-6-D | 15 mL/L | | |
| | THRU-CUP PEA-6-E | 50 mL/L | | |
| | Formaldehyde | 3 g/L | | |
| Water washing | | | R.T. | 1 |
| Drying | | | 60 | 10 |
| Heat treatment | | Conditions shown in Table 2 | | |
| Pickling | Sulfuric acid | 10 g/L | 25 | 10 sec |
| Electrolytic copper plating | THRU-CUP ECD-H (with the following ingredients) | Standard bath concentration | 40 | 23 |
| | Copper sulfate pentahydrate | 80 g/L | | |
| | Sulfuric acid | 200 g/L | | |
| | Hydrochloric acid | 0.05 g/L | | |
| | THRU-CUP ECD-1A | 1 mL/L | | |
| | THRU-CUP ECD-4B | 10 mL/L | | |
| | THRU-CUP ECD-H | 10 mL/L | | |
| Water washing | | | R.T. | 1 |
| Drying | | | 60 | 10 |
| Heat treatment | | | 200 | 60 |

**[Table 2]**

| | | Example 1 | Example 2 | Example 3 | Example 4 | Example 5 | Example 6 | Example 7 | Example 8 | Example 9 | Example 10 | Comparative Example 1 | Comparative Example 2 | Comparative Example 3 |
|---|---|---|---|---|---|---|---|---|---|---|---|---|---|---|
| Metal oxide layer | | Zinc oxide | Zinc oxide | Zinc oxide | Zinc oxide | Zinc oxide | Zinc oxide | Zinc oxide | Zinc oxide | Zinc oxide | Zinc oxide | Zinc oxide | Zinc oxide | None |
| First heat treatment | Atmosphere | Air | Air | Air | Air | Air | Air | Air | Air | Air | Air | None | Air | None |
| | Temperature | 300°C | 400°C | 500°C | 300°C | 300°C | 500°C | 500°C | 500°C | 500°C | 500°C | | 300°C | |
| | Duration | 30 min | 30 min | 30 min | 15 min | 60 min | 30 min | 30 min | 30 min | 30 min | 30 min | | 30 min | |
| Second heat treatment | Atmosphere | Nitrogen | Nitrogen | Nitrogen | Nitrogen | Nitrogen | Nitrogen | Nitrogen | Nitrogen | Nitrogen | Nitrogen | Nitrogen | None | None |
| | Temperature | 400°C | 400°C | 400°C | 400°C | 400°C | 300°C | 500°C | 400°C | 400°C | 400°C | 400°C | | |
| | Duration | 60 min | 60 min | 60 min | 60 min | 60 min | 60 min | 30 min | 15 min | 30 min | 90 min | 60 min | | |
| Other treatment | | | | | | | | | | | | | | Ti-Cu sputtering |
| Adhesion | | S | S | S | S | S | S | B | S | S | S | C | C | C |
| Peel strength (gf/cm) | | 538 | 499 | 518 | 444 | 527 | 340 | 126 | 311 | 405 | 431 | 10 | 24 | 37 |

Table 2 shows that a plating deposit with good adhesion to a glass substrate can be produced by the method of producing a plating deposit of each of the examples including: (1) forming a metal oxide layer on a surface of a glass substrate; (2) performing a first heat treatment after the step (1); (3) forming an electroless copper plating deposit on the metal oxide layer after the step (2); (4) performing a second heat treatment after the step (3); and (5) forming an electrolytic copper plating deposit on the electroless copper plating deposit after the step (4) .

FIG. 1A shows an electron microscopic image of the plating deposit in Example 1, and FIG. 1B shows an electron microscopic image of the plating deposit formed by a copper sputtering process in Comparative Example 3. Comparative Example 3 is poor at coating the inside of the through holes in the substrate. In contrast, FIG. 1A shows that the production method of the present application is excellent in deposition and adhesion to the inside of the through holes in the substrate.

## Claims

1. A method of producing a plating deposit, comprising:
(1) forming a metal oxide layer on a surface of a glass substrate;
(2) performing a first heat treatment after the step (1) ;
(3) forming an electroless copper plating deposit on the metal oxide layer after the step (2);
(4) performing a second heat treatment after the step (3); and
(5) forming an electrolytic copper plating deposit on the electroless copper plating deposit after the step (4).

2. The method of producing a plating deposit according to claim 1,
wherein the step (1) comprises:
(1-2) applying a catalyst to a surface of a glass substrate; and
(1-3) forming a metal oxide layer on the surface of the glass substrate, and
the step (1-2) and the step (1-3) are performed in this order.

3. The method of producing a plating deposit according to claim 1 or 2,
wherein the metal oxide is a zinc-containing oxide.

4. The method of producing a plating deposit according to any one of claims 1 to 3,
wherein the step (1) comprises forming the metal oxide layer using an aqueous solution containing zinc ions, nitrate ions, and an amine-borane compound.

5. The method of producing a plating deposit according to any one of claims 1 to 4,
wherein the step (3) comprises:
(3-1) applying a catalyst to a surface of the metal oxide layer; and
(3-2) forming an electroless copper plating deposit on the heat-treated metal oxide layer, and
the step (3-1) and the step (3-2) are performed in this order.

6. The method of producing a plating deposit according to any one of claims 1 to 5,
wherein the step (4) is performed in an inert gas atmosphere.

7. The method of producing a plating deposit according to any one of claims 1 to 6,
wherein the step (5) comprises forming the electrolytic copper plating deposit using an electrolytic copper plating bath with a pH of 2.0 or less.
